# EUROPÄISCHE PATENTSCHRIFT

(11) **EP 1 428 260 B1**
(45) Veröffentlichungstag und Bekanntmachung des Hinweises auf die Patenterteilung: **08.03.2006**
(21) Anmeldenummer: 02769905.7
(22) Anmeldetag: 05.09.2002
(51) Int. Cl.: H01L 23/538

(54) **NICHT-LEITENDES, EIN BAND ODER EINEN NUTZEN BILDENDES SUBSTRAT, AUF DEM EINE VIELZAHL VON TRÄGERELEMENTEN AUSGEBILDET IST**
NON-CONDUCTIVE SUBSTRATE FORMING A STRIP OR A PANEL, ON WHICH A PLURALITY OF CARRIER ELEMENTS ARE CONFIGURED
SUBSTRAT NON CONDUCTEUR FORMANT UNE BANDE OU UN FLAN, SUR LEQUEL EST FORMEE UNE PLURALITE D'ELEMENTS DE SUPPORT

(30) Priorität: 17.09.2001 DE 10145752
(43) Veröffentlichungstag der Anmeldung: 16.06.2004
(73) Patentinhaber: Infineon Technologies AG, 81669 München (DE)
(72) Erfinder: BARCHMANN, Bernd, 93059 Regensburg (DE); HEINEMANN, Erik, 93049 Regensburg (DE); HEITZER, Josef, 93090 Bach/Donau (DE); PÜSCHNER, Frank, 93309 Kelheim (DE)
(74) Vertreter: Epping - Hermann - Fischer
(86) Internationale Anmeldenummer: PCT/DE2002/003284
(87) Internationale Veröffentlichungsnummer: WO 2003/028044

(56) Entgegenhaltungen:
- EP-A- 0 818 752
- DE-A- 19 623 826
- DE-A- 19 640 304
- DE-A- 19 708 617
- DE-C- 19 703 058
- DE-C- 19 735 404
- US-A- 5 255 430

## Beschreibung

Ein Trägerelement, das aus einem solchen Substrat herausgetrennt ist, ist aus den Figuren 8 und 9 der EP 0 671 705 A2 bekannt. Das dortige Trägerelement ist zum Einbau in eine Chipkarte vorgesehen, die sowohl kontaktbehaftet über eine Anzahl von Kontaktflächen als auch kontaktlos über eine Antennenspule, beispielsweise über transformatorische Kopplung, betrieben werden kann. Trägerelemente für Chipkarten dienen der mechanischen Halterung des Halbleiterchips und weisen außerdem die zur Kontaktierung des Chips nötigen Kontaktflächen auf. Sie werden sowohl in rein kontaktbehafteten Chipkarten eingesetzt, so daß ein Zugriff auf den Halbleiterchip nur über die Kontaktfläche möglich ist, als auch in sogenannten Kombikarten, bei denen zusätzlich ein kontaktloser Zugriff mittels Leiterschleifen in der Karte und/oder auf dem Trägerelement oder dem Halbleiterchip möglich ist. Die Leiterschleifen werden zu diesem Zweck mit Spulenanschlüssen des Halbleiterchips verbunden.

Die Trägerelemente werden üblicherweise nicht einzeln, sondern auf einem langen Band oder einem großflächigen Nutzen aus einem nicht-leitenden Material in großen Stückzahlen hergestellt. Dieses - im folgenden als Substrat bezeichnete - Band oder der Nutzen werden zusätzlich durch beispielsweise Stanzen von Ausnehmungen strukturiert und dann einseitig mit einer Kupferfolie kaschiert, die anschließend beispielsweise durch Ätzen strukturiert wird, so daß die Kontaktflächen für die einzelnen Trägerelemente gebildet werden. Alle leitenden Strukturen sind zunächst noch durch schmale Leitungen elektrisch leitend miteinander verbunden, um eine galvanische Oberflächenveredelung durchführen zu können.

Die Halbleiterchips werden auf der den Kontaktflächen gegenüberliegenden Seite des Substrats befestigt und mittels Bonddrähte durch die Ausnehmungen elektrisch mit den Kontaktflächen verbunden. Vor einem Funktionstest der Halbleiterchips, der noch im Band oder Nutzen stattfindet, werden die schmalen Leitungen mittels Stanzen durchtrennt, so daß die Kontaktflächen elektrisch voneinander isoliert sind.

Beim Trägerelement der EP 0 671 705 A2 ist die elektrische Verbindung zwischen dem Halbleiterchip und den Kontaktflächen über Drahtverbindungen (Bonddrähte) realisiert. Beim Versand der Chipkarten auf dem Postweg werden diese über Briefsortieranlagen transportiert und sortiert. Dabei werden die in der Chipkarte befindlichen Trägerelemente einem hohen mechanischen Biegestress ausgesetzt, der durch Richtungsänderungen innerhalb der Briefsortieranlage bedingt ist. Aufgrund der hohen Durchlaufgeschwindigkeiten, häufigen Richtungswechsel über bewegliche Rollen, die üblicherweise einen Durchmesser von zirka 40 mm aufweisen, und anderen konstruktiven Merkmalen einer Briefsortieranlage ist das Trägerelement zudem sehr hohen kinetischen Kräften ausgesetzt.

Die auftretenden Kräfte können im Einzelfall dazu führen, daß entweder der Halbleiterchip oder die Drahtverbindungen beim Durchlaufen der Briefsortieranlage beschädigt werden. Es ist deshalb üblich, die auftretenden Kräfte durch Erhöhung des Modulbiegewiderstandes im Halbleiterchip- und Drahtverbindungsbereich zu entkräften. Um eine Beschädigung des Halbleiterchips zu vermeiden, schlägt die DB 298 18 829 U1 vor, eine flächige Auflage außerhalb der eigentlichen Halbleiterchipfläche auf die Chipkarte aufzubringen, um eine Übertragung des elastischen Anpreßdrucks einer Transportwalze der Briefsortieranlage auf die Chipfläche zu vermeiden.

Alternativ ist es aus dem Stand der Technik bekannt, harte Abdeckmassen, die den Halbleiterchip und die Drahtverbindungen auf dem Trägerelement umgeben, mit einem hohen Elastizitäts-Modul einzusetzen. Zur Erhöhung des Modulbiegewiderstandes zur Entkräftung der im Halbleiterchip- und Drahtbereich auftretenden Kräfte kann auch ein sogenannter Hotmelt-Klebstoff verwendet werden. Dessen elastische Eigenschaften, die durch einen Sandwich-Aufbau noch verstärkt werden können, unterstützen die oben genannte Maßnahme wirkungsvoll. Eine weitere Maßnahme sind die Einführung von Soll-Knickstellen und Barrieren gegen eine Krafteinleitung im Bereich des Halbleiterchips und der Drahtverbindungen. An den Soll-Knickstellen knickt das Trägerelement ab und verhindert somit Risse in der Drahtverbindung oder einen Bruch des Halbleiterchips.

EP-A-0 818 752 offenbart ein Trägerelement mit Kontaktelemente in der Form von Leiterzügen zur Kontaktierung mit Flip-Chip-Kontakten.

DE-C-197 03 058 offenbart die Ausbildung einer Vielzahl von Trägerelementen auf einem nicht-leitenden Band.

Die Aufgabe der vorliegenden Erfindung es daher, ein Trägerelement, das auf einem Substrat hergestellt wird, anzugeben, bei dem eine hohe mechanische Zuverlässigkeit, insbesondere bei auf das Trägerelement einwirkenden Biegebelastungen, gegeben ist. Die auf einem nicht-leitenden Band oder einem Nutzen ausgebildeten Trägerelemente sollen darüber hinaus eine optimale Layout-Ausführung für Hochvolumen-Prozesse aufweisen.

Diese Aufgabe wird gemäß Anspruch 1 durch ein nicht-leitendes, ein Band oder einen Nutzen bildendes Substrat gelöst, auf dem eine Vielzahl an Trägerelementen, insbesondere zum Einbau in eine Chipkarte, ausgebildet ist, die jeweils durch eine Begrenzungslinie gebildet sind, welches Substrat eine Kontaktseite und eine der Kontaktseite gegenüberliegende Einsatzseite aufweist, wobei die Einsatzseite mit einer leitenden Einsatzseitenmetallisierung versehen ist, die derart ausgebildet ist, daß eine elektrische Verbindung zwischen der Einsatzseitenmetalliesierung und Kontaktstellen einer später auf die Einsatzseite aufzubringenden integrierten Schaltung mittels Flip-Chip-Kontaktierung erfolgen kann.

Die Erfindung ermöglicht eine mechanisch belastbares, kontaktloses Chipmoudul. Bereits dadurch, daß anstatt der üblichen elektrischen Verbindung zwischen der integrierten Schaltung (Halbleiterchip) und der Einsatzseitenmetallisierung mittels Bonddrähten eine an sich bekannte Flip-Chip-Kontaktierung vorgesehen wird, erhöht sich die mechanische Belastbarkeit und somit auch die Zuverlässigkeit eines Trägerelementes erheblich. Darüber hinaus läßt sich auch die Durchlaufgeschwindigkeit bei der Fertigung signifikant steigern, da bereits mit dem Aufbringen der integrierten Schaltung auf die Einsatzseite des Substrates alle elektrischen Verbindungen auf einmal hergestellt werden können. Bei einer konventionellen elektrischen Verbindung mittels Bonddrähten muß jeder Bonddraht hingegen separat mit einer Draht-Bond-Maschine hergestellt werden. Eine Flip-Chip-Kontaktierung ist zudem gegenüber Drahtverbindungen mechanisch stabiler, da die zwischen der Einsatzseitenmetallisierung und den Kontaktstellen der integrierten Schaltung vorgesehenen Lotballungen für einen elastischen Ausgleich bei auftretenden Biegebelastungen sorgen können.

Innerhalb jeder Begrenzungslinie weist die Einsatzseitenmetallisierung erfindungsgemäß eine Mehrzahl an Kontaktelementen auf, die zumindest teilweise zur Kontaktierung mit Flip-Chip-Kontakten der integrierten Schaltung vorgesehen sind. Mit anderen Worten bedeutet dies, daß in einer Ausgestaltung jedes Kontaktelement einer Kontaktstelle der integrierten Schaltung zugeordnet sein kann. Bevorzugt sind jedoch auch Kontaktelemente vorhanden, die keine elektrische Verbindung zu einer Kontaktstelle der integrierten Schaltung aufweisen. Hierdurch kann das Substrat durch diese Kontaktelemente mechanisch stabilisiert werden. Es wird eine Erhöhung des Modulbiegewiderstandes durch die nicht kontaktierten Kontaktelemente erzielt.

Wird ebenfalls auf der Kontaktseite des Substrates eine Kontaktseitenmetallisierung vorgesehen, so ist die Realisierung eines rein kontaktbehafteten Chipmodules oder eines hybriden Chipmodules möglich, das auch über die Einsatzseitenmetallisierung mit einer Antennenspule einer Chipkarte verbunden werden kann.

Bevorzugt umfaßt die Kontaktseitenmetallisierung eine Mehrzahl an elektrisch getrennten Kontaktflächen innerhalb jeder Begrenzungslinie, die in einer bevorzugten Ausgestaltung als ISO-Kontaktflächen ausgebildet sein können.

Die Kontaktflächen der Kontaktflächenmetallisierung weisen zumindest teilweise eine elektrische Verbindung zu den Kontaktelementen der Einsatzseitenmetallisierung auf, wodurch ein Signalpfad zwischen den extern zugänglichen Kontaktflächen und der integrierten Schaltung geschaffen ist. Die elektrische Verbindung wird vorzugsweise jeweils mittels einer durch das Substrat reichenden Durchkontaktierung hergestellt.

Die Durchkontaktierungen können dabei nicht an jeder beliebigen Stelle der Kontaktflächen beziehungsweise Kontaktelemente vorgenommen werden. Es sind nämlich vorgegebene ISO-Normen zu beachten, die eine klar definierte freizuhaltende Fläche vorgeben. Hierdurch bedingt ist die Lage der Durchkontaktierungen eingeschränkt. Die Durchkontaktierungen sind deshalb vorzugsweise jeweils in einem Durchkontaktierungsbereich der Kontaktflächen der Kontaktseitenmetallisierung angeordnet, der nicht zum Kontaktieren mit einem externen Lesegerät (ISO-Feld) bestimmt ist.

In einer bevorzugten Ausgestaltung weist die Kontaktseitenmetallisierung Bereiche innerhalb jeder Begrenzungslinie auf, die ein erhöhtes Widerstandsmoment im Bereich der später aufgebrachten integrierten Schaltung bewirken. Diese Bereiche sind vorzugsweise flächig ausgeführt und erstrecken sich wenigstens über die Länge einer Seitenkante der integrierten Schaltung. Die ein erhöhtes Widerstandsmoment bewirkenden Bereiche dienen dazu, Soll-Biegelinien innerhalb des Trägerelementes zu definieren. Die Soll-Biegelinien verlaufen dabei außerhalb des Bereiches, in dem die integrierte Schaltung angeordnet wird. Vorzugsweise erstrecken sich die Soll-Biegelinien parallel zu den Seitenkanten der integrierten Schaltung.

Zur Definition dieser Soll-Biegelinien kreuzen die Bereiche mit erhöhtem Widerstandsmoment eine Symmetrielinie, die zwischen den gegenüberliegenden Kontaktflächen der Kontaktflächenmetallisierung gebildet ist.

Die Kontaktelemente der Einsatzseitenmetallisierung, die innerhalb der Begrenzungslinien gelegen sind, sind erfindungsgemäß in Form von Leiterzügen ausgebildet, die jeweils ein erstes und ein zweites Ende aufweisen. Das erste Ende des Leiterzuges überlappt erfindungsgemäß mit einer der Durchkontaktierungen und steht mit dieser in elektrischer Verbindung. Das zweite Ende hingegen weist eine erste Kontaktfläche zur Kontaktierung mit einer Kontaktstelle der integrierten Schaltung auf.

In einer vorteilhaften Ausgestaltung weisen zumindest manche der Leiterzüge zumindest eine weitere Kontaktfläche auf, die mit der ersten Kontaktfläche des Leiterzuges entweder direkt oder über einen Abschnitt des mit der ersten Kontaktfläche verbundenen Leiterzuges in elektrischem Kontakt steht oder die mit dem Leiterzug über einen Leiterzugabzweig in elektrischem Kontakt steht, wobei die weiteren Kontaktflächen jeweils zur Kontaktierung mit einer Kontaktstelle der integrierten Schaltung vorgesehen sind. Ein vorzugsweise als Leiterzug ausgebildetes Kontaktelement der Einsatzseitenmetallisierung kann folglich am oder in der Nähe des zweiten Endes mehr als eine Kontaktfläche aufweisen. Es wird jedoch üblicherweise nur eine dieser Kontaktflächen mit einer Kontaktstelle der integrierten Schaltung verbunden.

Das Vorsehen mehrerer Kontaktflächen ermöglicht es, daß verschiedene Kontaktstellen-Layouts der integrierten Schaltung berücksichtigt werden können. Hierdurch kann der Logistikbeziehungsweise Lageraufwand gering gehalten werden, da grundsätzlich nur ein Substrat bereitgestellt werden muß, um unterschiedliche integrierte Schaltungen verbinden zu können. Die zwei oder mehreren Kontaktflächen eines Kontaktelementes können dabei in unmittelbarer Nachbarschaft zueinander gelegen sein, das heißt ineinander übergehen und somit eine Kontaktfläche mit größerer Fläche bilden. Die Kontaktflächen können aber auch beabstandet voneinander ausgeführt sein und durch einen Leiterzugabschnitt oder einen Leiterzugabzweig, das heißt eine Gabelung des Leiterzuges, miteinander in elektrischer Verbindung stehen.

Eine weitere Ausbildung sieht vor, daß die Kontaktflächen und die weiteren Kontaktflächen eines Kontaktelementes der Einsatzseitenmetallisierung derart ausgestaltet sind, daß sie als Kontrollmarken beim Aufbringen der integrierten Schaltung dienen, in denen die Kontaktflächen über die Seitenkanten der integrierten Schaltung geringfügig hinausragen. Hierdurch ist es möglich, die Ablagegenauigkeit der integrierten Schaltung visuell schnell überprüfen zu können, da bei einem "sauberem" Bestückvorgang immer ein Teil der Kontaktfläche eines Kontaktelementes über die Seitenkante der integrierten Schaltung übersteht. Die Kontaktflächen werden folglich größer als eigentlich notwendig ausgeführt. Die größere Kontaktfläche erhöht darüber hinaus gleichzeitig die "Trefferfläche" für die Kontaktstelle der integrierten Schaltung bei dem Bestückungsvorgang. An Stellen, an denen diese Vergrößerung der Kontaktfläche nicht möglich ist, können auch andere Metallisierungsstrukturen zusätzlich zu den Kontaktflächen der Kontaktelemente eingeführt werden.

Die Erfindung sieht vor, daß zumindest manche der Leiterzüge der Kontaktelemente mit flächigen Metallisierungen versehen sind, die zur Erhöhung der Biegesteifigkeit des Substrates dienen. Die Ausführung der Kontaktelemente als Leiterzüge bedingt zunächst, daß zunächst nur ein kleiner Teil der Fläche innerhalb der Begrenzungslinie, die das Trägerelemente definiert, metallisiert ist. Je größer die metallisierte Fläche auf der Einsatzseite des Trägerelementes ist, desto biegesteifer wird das Trägerelement. Im Ergebnis wird durch diese Ausgestaltung sichergestellt, daß ein mehr oder minder beidseitig metallisiertes Substrat bereitgestellt wird. Die Steifigkeit eines derart ausgebildeten Trägerelementes läßt sich darüber hinaus auch durch die Dicke der Einsatzseitenbeziehungsweise Kontaktseitenmetallisierung steuern. Die flächigen Metallisierungen sind dabei vorzugsweise innerhalb der jeweiligen Begrenzungslinien eines Trägerelementes ausgebildet.

Zur Vermeidung von Kurzschlüssen werden die flächigen Metallisierungen, die mit den Leiterzügen der Einsatzseitenmetallisierung verbunden sind, in einem Bereich außerhalb der später aufzubringenden integrierten Schaltung vorgesehen.

Üblicherweise weist ein Substrat, auf dem die Trägerelemente während der Herstellung ausgebildet sind, Indexierungslöcher auf. Zur Versteifung des Substrates sind auf der Einsatzseite und/oder,der Kontaktseite die Indexierungslöcher von Metallisierungen umgeben. Hierdurch kann das Handling der Substrate während der Fertigung verbessert werden.

Das Substrat ist in einer vorteilhaften Ausgestaltung darüber hinaus mit Justiermarken für die Orientierung von Bestükkungsmaschinen versehen, wobei die Justiermarken Bestandteil der Einsatzseiten- und/oder der Kontaktseitenmetallisierung sind und bevorzugt im Bereich außerhalb jeweiliger Begrenzungslinien gelegen sind. Eine Anbindung der Justiermarken an die Kontaktflächen der Kontaktflächenmetallisierung innerhalb jeweiliger Begrenzungslinien ist ebenfalls denkbar.

Zur weiteren Erhöhung der Steifigkeit des Substrates und somit für ein besseres Handling weist das Substrat Querstege zwischen benachbarten Trägerelementen auf, die Bestandteil der Einsatzseiten- oder Kontaktseitenmetallisierung sind.

In einer weiter vorteilhaften Ausgestaltung umfaßt die Einsatzseitenmetallisierung im Bereich der später aufzubringenden integrierten Schaltung Abstandshalter, die für eine Planparallelität zwischen der integrierten Schaltung und der Einsatzseite des Substrates sorgen. Diese Abstandshalter, die ebenfalls Teil der Einsatzseitenmetallisierung sein können, aber nicht müssen, tragen dazu bei, daß sich die integrierte Schaltung beim Aufbringen auf das Trägerelement nicht durchbiegt. Das Aufbringen des sogenannten "Underfill" wird hierdurch ebenfalls erleichtert. Beim Aushärten des Underfills, das üblicherweise unter Druck erfolgt, wird somit ebenfalls eine Durchbiegung vermieden.

In einer weiteren Ausgestaltung ist auf der Einsatzseite des Substrates ein Versteifungsrahmen angeordnet, der den Bereich, der für die später aufzubringende integrierte Schaltung vorgesehen ist, umgibt. Bevorzugt ist der Versteifungsrahmen Teil der Einsatzmetallisierung, wobei dieser im Kreuzungs- oder Überlappungsbereich mit Kontaktelementen der Einsatzseitenmetallisierung Unterbrechungen aufweist zur Vermeidung von Kurzschlüssen. Denkbar ist jedoch auch, daß der Versteifungsrahmen aus einem nicht-leitenden Material besteht und den Bereich der integrierten Schaltung vollständig umgibt.

Üblicherweise besteht das Substrat aus einem Epoxy-Trägerband. Diese weisen eine Dicke von 110 µm auf, auf die dann der Kleber und darauf die Metallisierung (en) aufgebracht werden. Durch das beidseitige Metallisieren wird das Substrat zwar sehr steif, jedoch auch verhältnismäßig teuer. Vorzugsweise besteht das Substrat deshalb aus PEN, PET, PI oder Papier, das gemäß den oben aufgeführten Ausgestaltungsformen metallisiert und gegebenenfalls durchkontaktiert ist. Bei Verwendung der oben genannten Materialien brauchen die Einsatzseiten- und Kontaktseitenmetallisierung nicht auflaminiert werden, sondern sie können aufgewachsen werden. Hierdurch kann auf einen Klebstoff verzichtet werden und die Metallisierungen können wesentlich dünner ausgeführt werden. Eine durch einen Aufwachsprozeß erzeugte Kontaktseiten- und Einsatzseitenmetallisierung ermöglicht eine Dicke von weniger als 5 µm. Die Dicke des Substrates mit einem der obigen Materialien beträgt dann vorzugsweise in etwa 50 oder 70 µm. Jedoch sind selbstverständlich auch andere Dicken möglich, falls dies für das Handling vorteilhaft ist. Die Substitution des Epoxy-Trägersubstrates ermöglicht insgesamt ein wesentlich dünneres Trägerelement.

Die Substitution des Exoxyd-Substrates durch andere Materialien ist erst durch die Flip-Chip-Kontaktierung möglich, da hier maximale Verarbeitungstemperaturen von zirka 140°C auftreten, während bei konventionellen Chipmodulen, die sich einer elektrischen Verbindung über Bonddrähte bedienen, Temperaturen von zirka 230°C auftreten. Erst der Einsatz der Flip-Chip-Technologie ermöglicht somit die Verwendung neuerer und kostengünstigerer Materialien, was insbesondere in einem Hochvolumen-Herstellungsprozeß von großer Bedeutung ist.

Die Erfindung wird nachfolgend anhand mehrerer Ausführungsbeispiele mit Hilfe von Figuren näher erläutert. Dabei zeigen:
- Figur 1: die Kontaktseitenansicht eines Ausschnittes aus einem Substratband in einem ersten Ausführungsbeispiel,
- Figur 2: die Einsatzseitenansicht eines Ausschnittes aus einem Substratband gemäß dem ersten Ausführungsbeispiel,
- Figur 3: die Kontaktseitenansicht eines Ausschnitts aus einem Substratband gemäß einem zweiten Ausführungsbeispiel,
- Figur 4: die Einsatzseitenansicht eines Ausschnittes aus einem Substratband gemäß dem zweiten Ausführungsbeispiel,
- Figur 5: eine detailliertere Darstellung der Kontaktseite eines Trägerelementes gemäß dem zweiten Ausführungsbeispiel,
- Figur 6: eine detailliertere Ansicht der Einsatzseite eines Trägerelementes gemäß dem zweiten Ausführungsbeispiel,
- Figur 7: die Kontaktseitenansicht eines Ausschnittes aus einem Substratband eines dritten Ausführungsbeispieles,
- Figur 8: die Einsatzseitenansicht eines Ausschnittes aus einem Substratband gemäß dem dritten Ausführungsbeispiel,
- Figur 9: eine detailliertere Darstellung der Einsatzseite eines Trägerelementes gemäß dem dritten Ausführungsbeispiels und
- Figur 10: eine detaillierte Darstellung der Einsatzseite eines Trägerelementes eines vierten Ausführungsbeispieles.

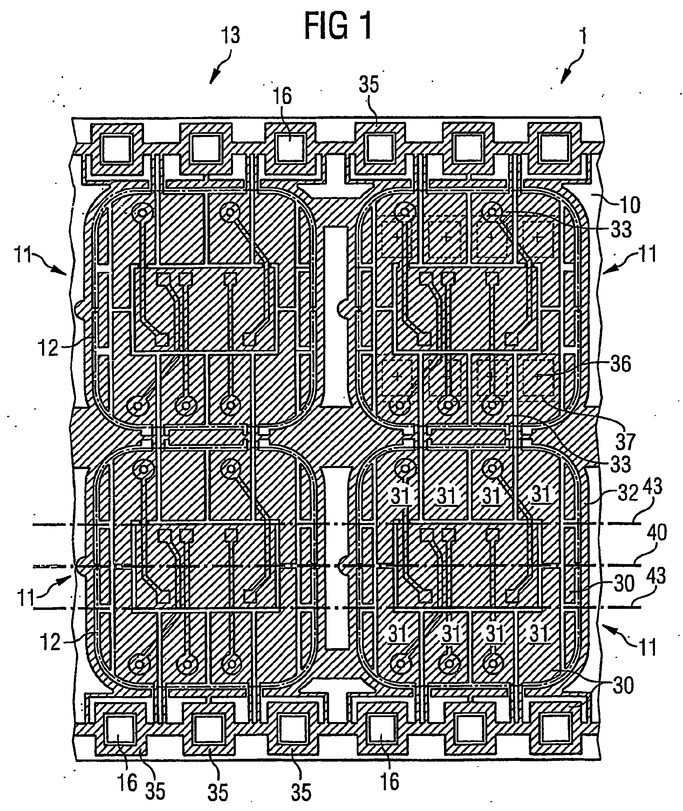

Die Figur 1 zeigt einen Ausschnitt aus einem Band 1, auf dem vier Trägerelemente 11 paarweise ausgebildet sind. Es ist allerdings möglich, eine größere Anzahl als zwei Trägerelemente 11 nebeneinander auf dem Band 1 anzuordnen. Das Band 1 besteht aus einem nicht-leitenden Substrat 10, wobei als Material beispielsweise glasfaserverstärktes Epoxydharz, PEN, PET, PI oder Papier genommen werden kann. Die Verwendung der letztgenannten Materialien weist den Vorteil auf, daß diese gegenüber dem Epoxydharz eine um die Hälfte verringerte Dicke aufweisen.

Das Substrat 10 weist Indexierungslöcher 16 entlang beider Ränder auf, die dem Weitertransport mittels in die Indexierungslöcher 16 eingreifender Mitnehmer, beispielsweise bei der Bestückung des Bandes mit den integrierten Schaltungen, dienen. Die Außenkontur eines jeden Trägerelementes 11 ist jeweils durch eine strich-punktierte Begrenzungslinie 12 angedeutet. Die fertig bestückten Trägerelemente werden entlang dieser Begrenzungslinien 12 aus dem Band 1 gestanzt oder sonst wie herausgetrennt.

Die vorliegende Figur 1 zeigt die Kontaktseite des Substrates 10. Das nicht-leitende Substrat 10 ist beispielsweise mit einer Metallfolie, vorzugsweise einer Kupferfolie, kaschiert. Durch anschließendes Ätzen wurde diese Metallfolie strukturiert, so daß Kontaktflächen 31 innerhalb der Begrenzungali - nie 12 sowie weitere Kontaktflächen, die außerhalb der Begrenzungslinie 12 des Trägerelementes liegen, entstanden. Die Kontaktflächen 31 und die weiteren Kontaktflächen sind über schmale Leitungen alle in bekannter Weise miteinander verbunden. Diese elektrische Kurzschluß ist nötig, wenn die Kontaktflächen 31 und die weiteren Kontaktflächen galvanisch oberflächenveredelt werden.

Bei der Verwendung von PEN, PET, PI oder Papier als Substratmaterial anstelle des Epoxydharzes brauchen die Kontaktflächen 31 nicht auflaminiert werden, sondern sie können in einem Aufwachsprozeß aufgebracht werden. Hierzu wird zunächst auf das Substrat eine wenige Nanometer dicke Metallschicht, zum Beispiel aus Kupfer, aufgesputtert. Nach dem Stanzen der Durchkontaktierung findet eine galvanische Nachverstärkung statt, so daß die zunächst noch ganzflächige Metallisierung eine Dicke von einigen µm aufweist. Im nächsten Schritt wird die Metallisierung in der gewünschten Form strukuriert und galvanisch, zum Beispiel mit Nickel und Kupfer, veredelt. Die galvanische Veredelung könnte auch stromlos erfolgen, wodurch ein elektrischer Kurzschluß zwischen den Kontaktflächen und den weiteren Kontaktflächen nicht notwendig ist. Das erfindungsgemäße Vorgehen ermöglicht einen Verzicht auf die Verwendung von Klebstoff zum Aufbringen der Metallisierung. Zudem kann die Kontaktseitenmetallisierung wesentlich dünner ausgeführt werden, wodurch Kosteneinsparungen möglich sind. Üblicherweise weist die Kontaktseitenmetallisierung dann nur noch eine Dicke von weniger als 40 µm auf. Das Substrat beziehungsweise die Dicke des Substrates kann den Bedürfnissen an das Handling angepaßt werden. Übliche Substratdicken sind 50 bis 125 µm, wobei selbstverständlich auch andere Dicken möglich sind.

Um die Indexierungslöcher 16 herum sind Metallisierungen 35 vorgesehen, die jeweils durch einen Steg miteinander verbunden sind. Die Metallisierungen 35.tragen dazu bei,: daß die Steifigkeit und somit das Handling des Substrates 10 beziehungsweise des Bandes 1 verbessert wird.

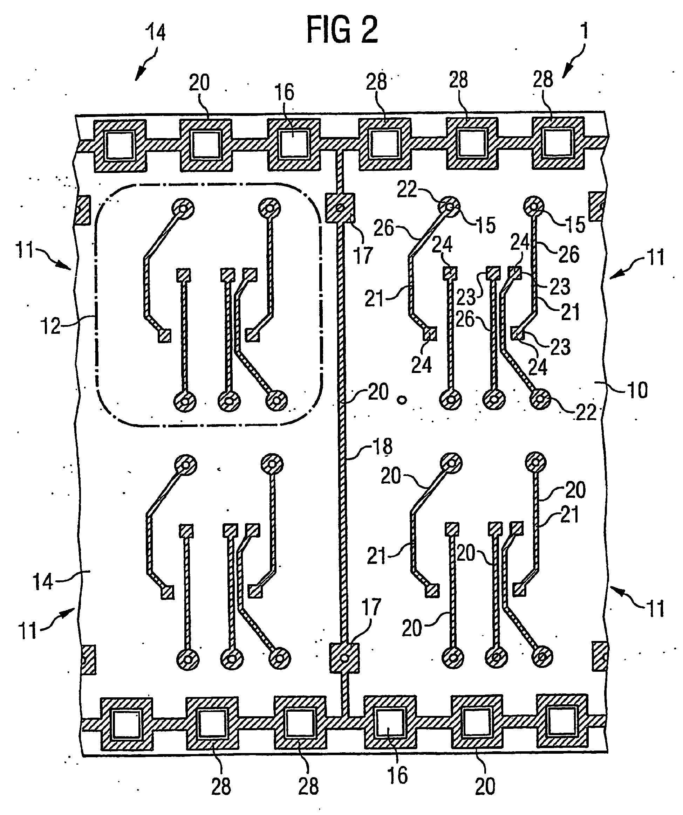

Die Figur 2 zeigt die andere Seite (also die Einsatzseite) des Substrates 10, auf der die (nicht dargestellte) integrierte Schaltung montiert wird. Die auf der Einsatzseite 14 aufgebrachte Einsatzseitenmetallisierung 20, die aus den Leiterstrukturen 26, 24, 22, 28, 17, 18 besteht, kann durch Metallfolien kaschieren und ätzen erzeugt werden. Alternativ kann die Einsatzseitenmetallisierung, wie bereits zur Figur 1 beschrieben, durch einen Aufwachsprozeß entstanden sein.

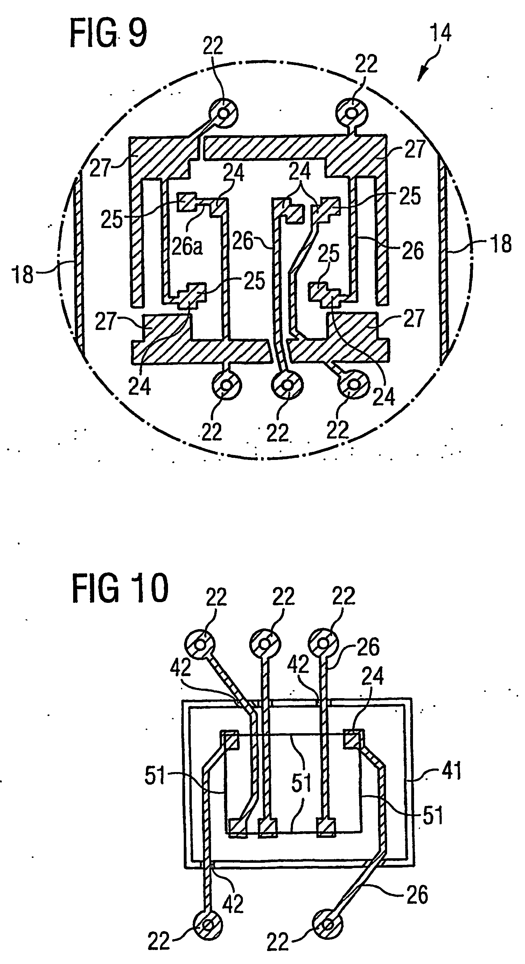

Das Substrat 10 ist relativ flexibel. In einer Chipkarte würde eine darauf montierte integrierte Schaltung erheblichen Biegebelastungen ausgesetzt sein. Größere Halbleiterchips könnten sogar brechen. Aus diesem Grund wird ein (in Figur 2 nicht dargestellter) Verstärkungsrahmen auf der Einsatzseite des Trägerelementes um den Bereich der integrierten Schaltung herum aufgebracht. Der Verstärkungsrahmen ist vorzugsweise aus Metall, er kann aber auch aus einem anderen Material bestehen. Da die Trägerelemente üblicherweise in die Chipkarte eingeklebt werden, muß entlang des Randes der Trägerelemente Platz für den Kleber sein, so daß der Verstärkungsrahmen nur knapp außerhalb des Bereiche der Kontaktflächen 24, die Bestandteil der Einsatzseitenmetallisierung 20 sind, verläuft. Ein entsprechendes Ausführungsbeispiel ist in Figur 10 dargestellt.

Im nachfolgenden wird auf besondere konstruktive Ausgestaltungen der Einsatzseiten- und Kontaktseitenmetallisierung eingegangen.

Die Einsatzseitenmetallisierung weist eine Mehrzahl an Kontaktelementen 21 auf, die im vorliegenden Ausführungsbeispiel gemäß Figur 2 jeweils zur späteren Kontaktierung mit Kontaktstellen der integrierten Schaltung vorgesehen sind. Die Kontaktelemente 21 sind in Form von Leiterzügen 26 mit jeweils einem ersten Ende 22 und einem zweiten Ende 23 ausgeführt. Das erste Ende 22 weist beispielhaft jeweils einen ringförmigen Verlauf auf, dessen Zentrum mit einer Durchkontaktierung verbunden ist. Prinzipiell könnte das erste Ende 22 jede beliebige Form, zum Beipiel rechteckig, ellipsoid, polygonförmig, usw., aufweisen. Die Durchkontaktierung 15 erstreckt sich durch das Substrat hindurch bis zu entsprechenden Kontaktflächen 31. Die zweiten Enden 23 sind jeweils mit einer hier in etwa quadratisch ausgebildeten Kontaktfläche 24 versehen. Die Anordnung der. Kontaktflächen 24 entspricht dabei der Anordnung der Kontaktstelle des hier nicht gezeigten Halbleiterchips. In welcher Weise die Kontaktelemente der Einsatzseitenmetallisierung zu den Kontaktflächen 31 der Kontaktseitenmetallisierung angeordnet sind, ergibt sich aus der Figur 1. Die Kontaktflächen 24 der Einsatzseitenmetallisierung kommen in dem vorliegenden Beispiel in einem als Kontaktfläche ausgebildeten Zentralbereich 34 der Kontaktseitenmetallisierung zum Liegen. In diesem Zentralbereich wird die (aus Figur 1 nicht ersichtliche) integrierte Schaltung (auf der Einsatzseite) angeordnet.

In dem rechten oberen Trägerelement der Figur 1 sind die durch eine ISO-Norm festgelegten Bereiche 37 ersichtlich. Innerhalb der mit dem Bezugszeichen 37 gekennzeichneten Fläche kommen die Kontaktstifte eines Lesegerätes zum Liegen. Der von dem ISO-Feld 37 eingenommene Bereich muß aufgrund der Vorschriften frei von einer Durchkontaktierung sein. Als Durchkontaktierungsbereiche 33 kommen somit nur noch diejenigen Bereiche jeder Kontaktfläche 31 in Frage, die außerhalb des ISO-Feldes 37 gelegen sind. Im vorliegenden Ausführungsbeispiel der Figur 1 befinden sich die Durchkontaktierungsbereiche 33 von der Kontaktfläche 31 aus betrachtet nahe der Begrenzungslinie 12. Zu bevorzugen ist es jedoch, wenn der Durchkontaktierungsbereich 33 von der Kontaktfläche 31 aus betrachtet in Richtung des Zentralbereichs 34 gelegen ist.

Die Kontaktseitenmetallisierung weist darüber hinaus Bereiche 32 auf, die ein erhöhtes Widerstandsmoment im Bereich der später zu montierenden integrierten Schaltung bewirken. Hierdurch wird die Biegesteifigkeit des Trägerelementes 11 erhöht. Die Bereiche 32 sind dabei derart ausgestaltet, daß sie in etwa die Breite des Zentralbereiches 34 aufweisen. Die Bereiche 32 erstrecken sich dabei über eine Symmetrielinie 40 des Trägerelementes 11. Dadurch, daß die Breite der Bereiche 32 mit der Breite des Zentralbereiches 34 in etwa übereinstimmt, ergeben sich zwei parallel zu der Symmetrielinie 40 verlaufende Soll-Biegelinien 43, entlang derer das Trägerelement bei einer zu großen Biegebelastung abknicken kann. Hierdurch ist sichergestellt, daß auf die integrierte Schaltung keine Biegebelastungen einwirken.

Die Metallisierungen 17, 18, 28, die Teil der Einsatzseitenmetallisierung sind, dienen vorteilhafterweise zur Stabilisierung des Substrates 10. Die Metallisierungen 28 umgeben die Indexierungslöcher 16 und sind miteinander über Stege verbunden. Querstege 18 verlaufen im vorliegenden Ausführungsbeispiel zwischen benachbarten Trägerelementen 11 und erstrecken sich entlang der Ränder des Bandes 1. Justiermarken 17 sind Bestandteile der Querstege 18. Die Querstege 18 haben neben der Stabilisierung keine weitere Funktion, während die Justiermarken 17 für optische Erkennungssysteme verwendbar sind. Die Justiermarken 17 sind im vorliegenden Ausführungsbeispiel als Quadrate ausgebildet. Je nach Erkennungssystem könnten die Justiermarken auch als Kreuze, Kreise, Rechtecke oder anderswie ausgestaltet sein. Die Justiermarken 17 müssen auch nicht notwendigerweise Bestandteil der Querstege 18 sein.

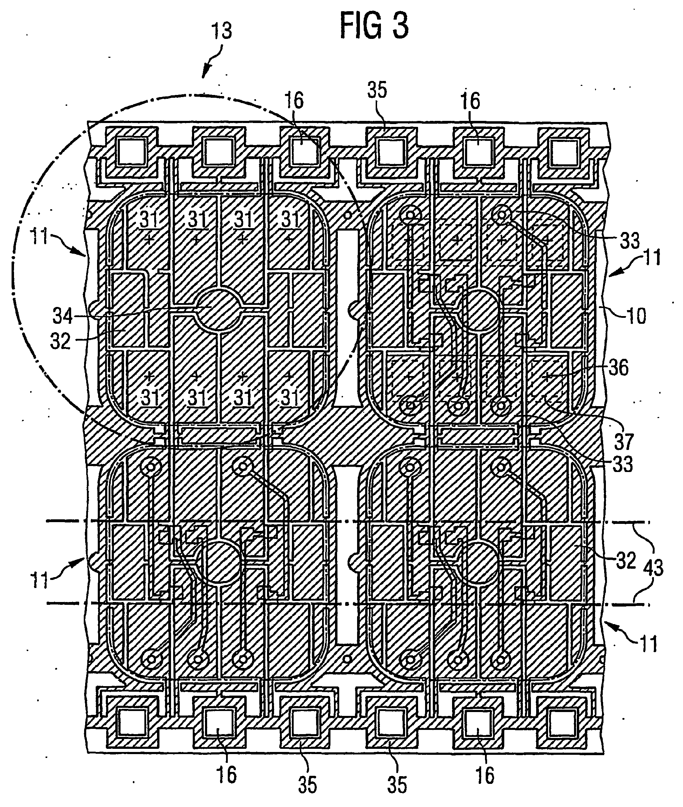

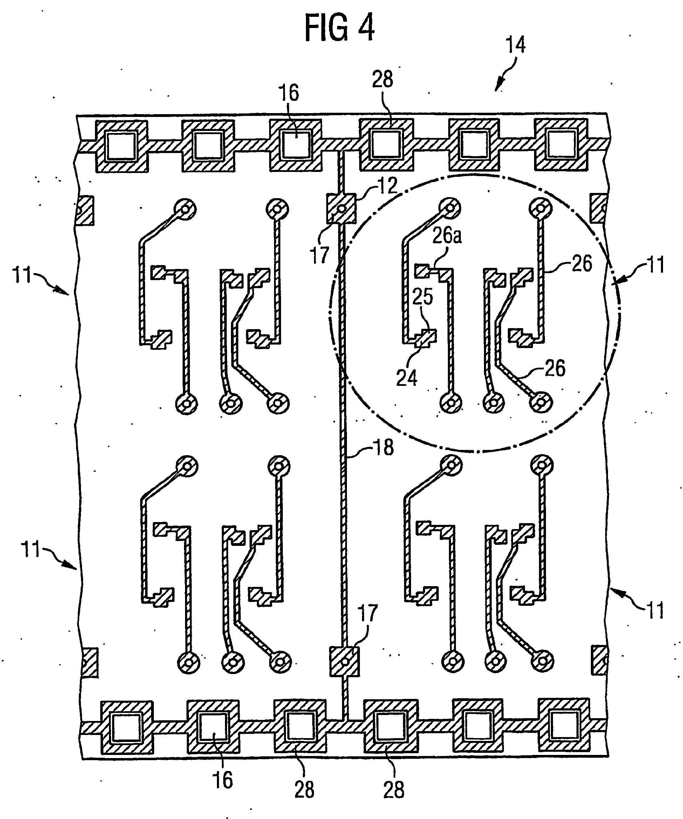

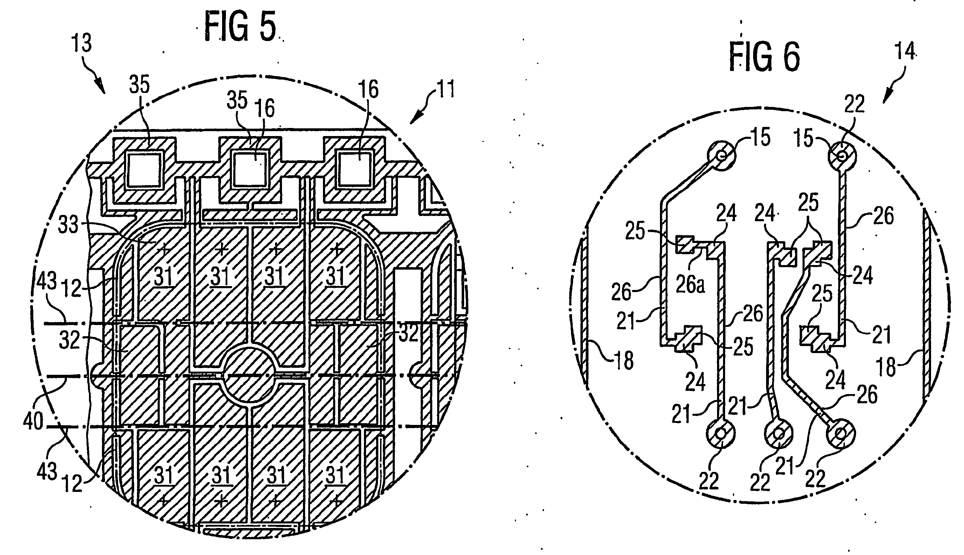

Die Figuren 3 und 4 zeigen ein zweites Ausführungsbeispiel, wobei in Figur 3 ein Ausschnitt aus der Kontaktseite des Substrates gezeigt ist, während in Figur 4 ein Ausschnitt aus der Einsatzseite des Substrates dargestellt ist. Die Figuren 5 und 6 zeigen jeweils die Kontaktseiten- beziehungsweise Einsazseitenansicht eines Trägerelementes gemäß dem zweiten Ausführungsbeispiel in vergrößerter Darstellung. Die Kontaktseitenmetallisierung des zweiten Ausführungsbeispieles unterscheidet sich von dem des ersten Beispieles dadurch, daß der Zentralbereich 34 nicht als Rechteck ausgebildet ist, das eine größere Fläche einnimmt als die integrierte Schaltung. Der Zentralbereich 34 ist im vorliegenden Ausführungsbeispiel vielmehr kreisförmig ausgebildet und nimmt eine kleinere Fläche als die auf der Einsatzseite aufzubringende integrierte Schaltung ein. Diese Ausgestaltung weist den Vorteil auf, daß die Kontaktflächen 31 in Richtung des Zentralbereiches eine größere Fläche aufweisen können, welche dann als Durchkontaktierungsbereich verwendet werden können. Darüber hinaus sind die Bereiche 32 mit einem erhöhten Widerstandsmoment vergrößert. Die Vergrößerung betrifft dabei eine größere Ausdehnung in Richtung des Zentralbereiches, wodurch der Modulbiegewiderstand des Trägerelementes erhöht wird. Die Breite des Bereiches 32 der Figur 3 entspricht der Breite in der Figur 1, wobei durch die Enden Soll-Biegelinien 43 definiert sind. Bei einer Durchbiegung des Trägerelementes bzw. des Chipmodules würden zwar die mittigen Kontaktflächen 31 gebogen, die integrierte Schaltung liegt jedoch in einem Bereich innterhalb der Sollbiegelinien 43 und ist deshalb geschützt.

Wie aus dem oberen rechten Trägerelement 11 der Figur 3 ersichtlich ist, erfüllen die Kontaktflächen 31 die Erfordernisse der ISO-Norm 7816-2. Die Anordnung der ISO-Felder 37 und die Position 36, an denen die Kontaktstifte des Lesegerätes auf die Kontaktflächen 31 treffen, entsprechen der Ausgestaltung der Figur 1.

Die Gestaltung der Einsatzseitenmetallisierung des zweiten Ausführungsbeispieles entspricht im wesentlichen der Gestaltung des ersten Ausführungsbeispieles. Die Einsatzseitenmetallisierung unterscheidet sich jedoch dadurch, daß die zweiten Enden 23 der Leiterzüge 26 jeweils eine weitere Kontaktfläche 25 aufweisen, wie dies gut aus Figur 6 ersichtlich ist. Die Kontaktfläche 24 und die Kontaktfläche 25 können dabei ineinander übergehen oder über einen Leiterzugabschnitt 26 miteinander in Verbindung stehen. Die Kontaktflächen 24 entsprechen dem Layout der Kontaktstellen einer ersten integrierten Schaltung, während die Anordnung der weitere Kontaktstellen 25 dem Layout der Kontaktstellen einer weiteren integrierten Schaltung entspricht. Mit einem einzigen Substrat ist es somit möglich, das Kontaktstellenlayout unterschiedlicher integrierter Schaltungen zu berücksichtigen. Denkbar wäre prinzipiell auch, die Kontaktflächen 24 oder die weiteren Kontaktflächen 25 als Bondpad zu verwenden.

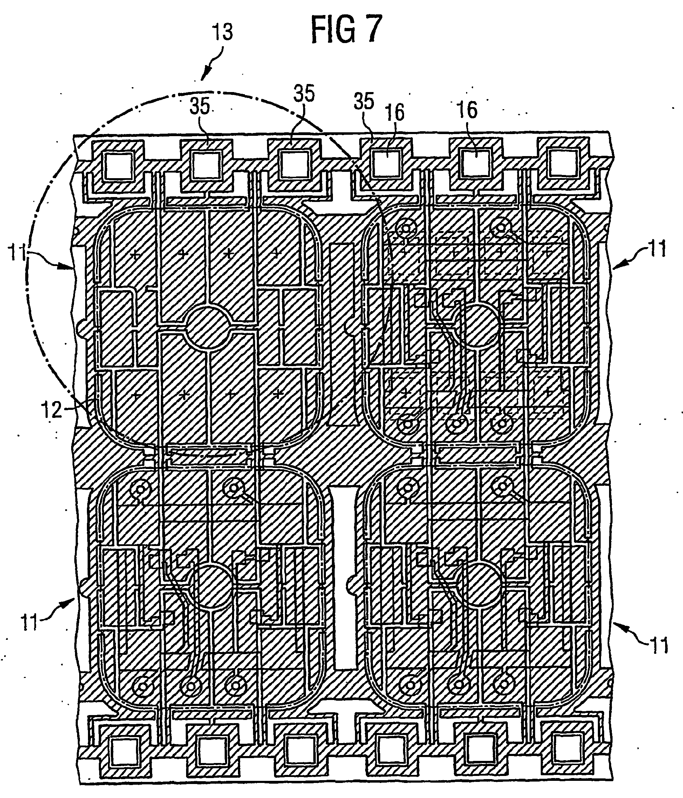

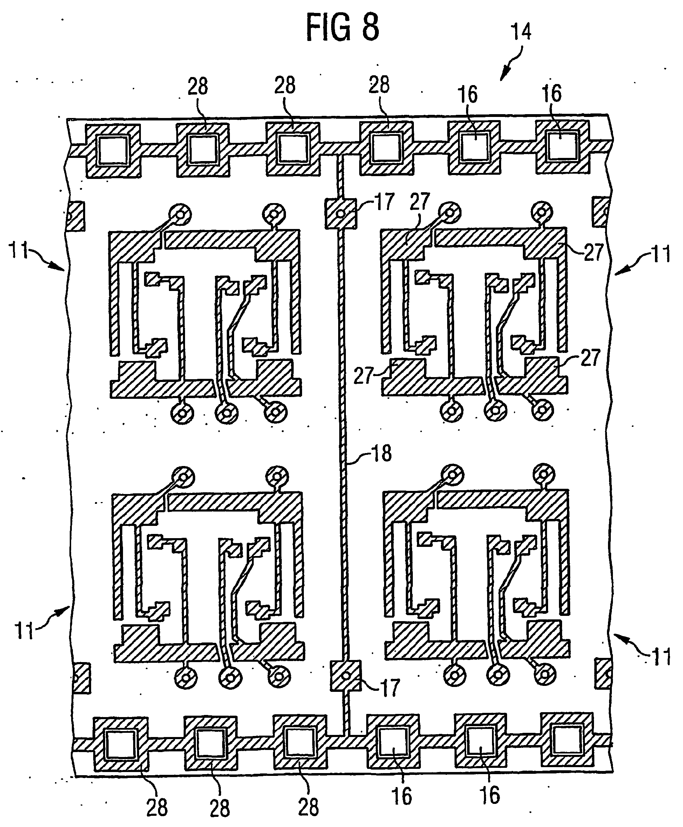

Die Figuren 7 und 8 zeigen jeweils die Kontaktseiten- beziehungsweise Einsatzseitenansicht eines Trägersubstrates gemäß einem dritten Ausführungsbeispiel, wobei das Layout der Einsatzseitenmetallisierung in Figur 9 vergrößert dargestellt ist. Das Layout der Kontaktseitenmetallisierung gemäß Figur 7 entspricht dabei dem Layout der Kontaktseitenmetallisierung des zweiten Ausführungsbeispiel gemäß den Figuren 3 und 5.

Die Einsatzseitenmetallisierung gemäß Figur 8 stellt eine Erweiterung des Layouts des zweiten Ausführungsbeispiels gemäß Figur 6 dar. Die Leiterzüge 26 sind hierbei mit flächigen Metallisierungen 27 versehen, die einen großen Teil der Fläche eines Trägerelementes 11 einnehmen. Durch die flächigen Metallisierungen 27 ist lediglich der Bereich ausgespart, in welchem die integrierte Schaltung aufzubringen ist. Die Anordnung der Kontaktflächen 24 und der weiteren Kontaktflächen 25 entspricht ansonsten der Anordnung aus dem zweiten Ausführungsbeispiel gemäß Figur 6. Es versteht sich von selbst, daß die flächigen Metallisierungen 27 jeweiliger Leiterzüge 26 keinen elektrischen Kontakt zueinander aufweisen. Die flächigen Metallisierungen 27 dienen in erster Linie dazu, die Steifigkeit des Trägerelementes weiter zu erhöhen. Durch die beidseitige Metallisierung des Substrates 10 ergibt sich eine höhere Steifigkeit, die die Verwendung eines dünneren Substratmaterials, zum Beispiel aus PEN, PET, PI oder Papier ermöglicht.

Wie weiter oben bereits ausgeführt, ermöglichen es diese Materialien, die Metallisierungen aufwachsen zu lassen und auf die Verwendung von Klebstoff bei der Verbindung der Metallisierung und des Substrates zu verzichten.

Figur 10 zeigt schließlich einen Teil der Einsatzseitenmetallisierung, aus der die Anordnung eines Versteifungsrahmens 41 ersichtlich wird. Der Versteifungsrahmen 41 kann, wie dies in dem vorliegenden Beispiel gezeigt ist, Teil der Einsatzseitenmetallisierung sein. An den Stellen, an denen er sich mit Leiterzügen oder Bereichen der Kontaktelemente 21 kreuzt, weist der Versteifungsrahmen 41 Unterbrechungen 42 auf zur Vermeidung von Kurzschlüssen. Auf den Versteifungsrahmen 41 könnte ein weiterer Verstärkungsrahmen aufgesetzt werden. Die Befestigung könnte beispielsweise mittels eines nicht-leitenden Klebers erfolgen.

Darüber hinaus ist aus der Figur 10 ersichtlich, wie die Kontaktflächen 24 als Kontrollmarken beim Aufbringen der integrierten Schaltung dienen können. Mit dem Bezugszeichen 51 sind die Seitenkanten einer später aufzubringenden integrierten Schaltung gekennzeichnet. Wird die integrierte Schaltung optimal auf das Substrat aufgebracht, so steht immer ein Teil der Kontaktflächen 24 über die Seitenkanten 51 über, wie dies in Figur 10 dargestellt ist. Idealerweise sind die Seitenkanten 51 der integrierten Schaltung und die Ränder der Kontaktflächen zueinander parallel ausgerichtet. Es ist somit eine visuelle Überprüfung möglich, ob die Flip-Chip-Kontaktierung der integrierten Schaltung mit den Kontaktflächen der Einsatzseitenmetallisierung korrekt stattgefunden hat.

### Bezugszeichenliste

- 1: Band
- 10: Substrat
- 11: Trägerelement
- 12: Begrenzungslinie
- 13: Kontaktseite
- 14: Einsatzseite
- 15: Durchkontaktierung
- 16: Indexierungsloch
- 17: Justiermarke
- 18: Quersteg

- 20: Einsatzseitenmetallisierung
- 21: Kontaktelemente
- 22: Erstes Ende
- 23: Zweites Ende
- 24: Kontaktfläche
- 25: Kontaktfläche
- 26: Leiterzug
- 26a: Leiterzugabschnitt
- 26b: Leiterzugabzweig
- 27: flächige Metallisierung
- 28: Metallisierung (um Indexierungsloch)

- 30: Kontaktseitenmetallisierung
- 31: Kontaktfläche
- 32: Metallisierungs-Bereich
- 33: Durchkontaktierungsbereich
- 34: Zentralbereich
- 35: Metallisierung (um Indexierungsloch)
- 36: ISO-Kontaktierposition
- 37: ISO-Kontaktfeld

- 40: Symmetrielinie
- 41: Versteifungsrahmen
- 42: Unterbrechung
- 43: Soll-Biegelinie

- 50: integrierte Schaltung
- 51: Seitenkanten (der integrierten Schaltung)

## Patentansprüche

1. Nicht-leitendes, ein Band oder einen Nutzen bildendes Substrat (10), auf dem eine Vielzahl an Trägerelementen (11), insbesondere zum Einbau in eine Chipkarte, ausgebildet ist, die jeweils durch eine Begrenzungslinie (12) gebildet sind, welches Substrat (10) eine Kontaktseite (13) und eine der Kontaktseite gegenüberliegende Einsatzseite (14) aufweist, wobei die Einsatzseite mit einer leitenden Einsatzseitenmetallisierung (20) versehen ist, die derart ausgebildet ist, dass eine elektrische Verbindung zwischen Kontaktstellen einer später auf der Einsatzseite aufzubringenden integrierten Schaltung und der Einsatzseitenmetallisierung mittels Flip-Chip-Kontaktierung erfolgen kann, und die Einsatzseitenmetallisierung (20) eine Mehrzahl an Kontaktelementen (21) innerhalb jeder Begrenzungslinie (12) aufweist, die zumindest teilweise zur Kontaktierung mit Flip-Chip-Kontakten der integrierten Schaltung vorgesehen sind, wobei die Kontaktelemente (21) der Einsatzseitenmetallisierung (20) in Form von Leiterzügen (26) ausgebildet sind, die jeweils ein erstes und ein zweites Ende (22, 23) aufweisen, wobei
zumindest manche der Leiterzüge (26) mit flächigen Metallisierungen (27) versehen sind, die zur Erhöhung der Biegesteifigkeit des Substrates (10) dienen.

2. Substrat nach Anspruch 1,
**dadurch gekennzeichnet, dass**
die Kontaktseite (13) des Substrates (10) mit einer Kontaktseitenmetallisierung (30) versehen ist.

3. Substrat nach Anspruch 2,
**dadurch gekennzeichnet, dass**
die Kontaktseitenmetallisierung (30) nach dem elektrischen Freistanzen eine Mehrzahl an elektrisch voneinander getrennten Kontaktflächen (31) innerhalb jeder Begrenzungslinie (12) umfasst.

4. Substrat nach Anspruch 3,
**dadurch gekennzeichnet, dass**
die Kontaktflächen (31) der Kontaktseitenmetallisierung (30) als ISO-Kontaktflächen ausgebildet sind.

5. Substrat nach Anspruch 3 oder 4,
**dadurch gekennzeichnet, dass**
die Kontaktflächen (31) der Kontaktseitenmetallisierung (30) zumindest teilweise eine elektrische Verbindung zu den Kontaktelementen (21) der Einsatzseitenmetallisierung (20) aufweisen.

6. Substrat nach Anspruch 5,
**dadurch gekennzeichnet, dass**
die elektrische Verbindung mittels durch das Substrat (10) reichender Durchkontaktierungen (15) hergestellt ist.

7. Substrat nach Anspruch 6,
**dadurch gekennzeichnet, dass**
die Durchkontaktierungen (15) jeweils in einem Durchkontaktierungs-Bereich (33) der Kontaktflächen (30) der Kontaktseitenmetallisierung (30) angeordnet sind, der nicht zum Kontaktieren mit einem externen Lesegerät (ISO-Feld) bestimmt ist.

8. Substrat nach einem der Ansprüche 2 bis 7,
**dadurch gekennzeichnet, dass**
die Kontaktseitenmetallisierung (30) Bereiche (32) innerhalb jeder Begrenzungslinie aufweist, die ein erhöhtes Widerstandsmoment im Bereich der integrierten Schaltung bewirken.

9. Substrat nach Anspruch 8,
**dadurch gekennzeichnet, dass**
die Bereiche (32) mit erhöhtem Widerstandsmoment die Symmetrielinie (40), die zwischen den gegenüberliegenden Kontaktflächen (31) der Kontaktflächenmetallisierung (30) gebildet ist, kreuzen.

10. Substrat nach Anspruch 9,
**dadurch gekennzeichnet, dass**
das erste Ende (22) des Leiterzuges (26) mit einer der Durchkontaktierungen (15) überlappt und mit dieser in elektrischer Verbindung steht.

11. Substrat nach Anspruch 9 oder 10,
**dadurch gekennzeichnet, dass**
das zweite Ende (23) eine erste Kontaktfläche (24) zur Kontaktierung mit einem Flip-Chip-Kontakt der integrierten Schaltung aufweist.

12. Substrat nach einem der Ansprüche 9 bis 11,
**dadurch gekennzeichnet, dass**
zumindest manche der Leiterzüge (26) zumindest eine weitere Kontaktfläche (25) aufweisen, die mit der ersten Kontaktfläche (24) des Leiterzuges entweder direkt oder über einen Abschnitt (26a) des mit der ersten Kontaktfläche (24) verbundenen Leiterzuges (26) in elektrischen Kontakt steht oder mit dem Leiterzug (26) über einen Leiterzugabzweig in elektrischen Kontakt steht, wobei die weiteren Kontaktflächen jeweils zur Kontaktierung mit einem Flip-Chip-Kontakt der integrierten Schaltung vorgesehen sind.

13. Substrat nach Anspruch 12,
**dadurch gekennzeichnet, dass**
die Kontaktflächen (24) und die weiteren Kontaktflächen (25) derart ausgestaltet sind, dass sie als Kontrollmarken beim Aufbringen der integrierten Schaltung dienen, indem die Kontaktflächen (24, 25) über die Seitenkanten (51) der integrierten Schaltung (50) geringfügig hinausragen.

14. Substrat nach Anspruch 13,
**dadurch gekennzeichnet, dass**
die flächigen Metallisierungen (27) innerhalb der jeweiligen Begrenzungslinien (12) eines Trägerelementes (11) ausgebildet sind.

15. Substrat nach Anspruch 13 oder 14,
**dadurch gekennzeichnet, dass**
die flächigen Metallisierungen (27) in einem Bereich außerhalb der später aufzubringenden integrierten Schaltung vorgesehen sind.

16. Substrat nach einem der vorhergehenden Ansprüche,
**dadurch gekennzeichnet, dass**
das Substrat (10) Indexierungslöcher (16) aufweist, die auf der Einsatzseite (14) und/oder der Kontaktseite (13) zur Versteifung des Substrates von Metallisierungen (28, 35) umgeben sind.

17. Substrat nach einem der vorhergehenden Ansprüche,
**dadurch gekennzeichnet, dass**
das Substrat mit Justiermarken (17) für die Orientierung von Bestückungsmaschinen versehen ist, die Bestandteil der Einsatzseiten- und/oder der Kontaktseitenmetallisierung (20, 30) sind.

18. Substrat nach einem der vorhergehenden Ansprüche,
**dadurch gekennzeichnet, dass**
das Substrat Querstege (18) zwischen benachbarten Trägerelementen (11) aufweist, die Bestandteil der Einsatzseiten- und/oder Kontaktseitenmetallisierung (20, 30) sind.

19. Substrat nach einem der vorhergehenden Ansprüche,
**dadurch gekennzeichnet, dass**
die Einsatzseitenmetallisierung (20) im Bereich der später aufzubringenden integrierten Schaltung Abstandshalter umfasst, die für eine Planparallelität zwischen der integrierten Schaltung und der Einsatzseite (14) des Substrates (10) sorgen.

20. Substrat nach einem der vorhergehenden Ansprüche,
**dadurch gekennzeichnet, dass**
auf der Einsatzseite (14) des Substrates (10) ein Versteifungsrahmen (41) angeordnet ist, der den Bereich, der für die später aufzubringende integrierte Schaltung vorgesehen ist, umgibt.

21. Substrat nach Anspruch 20,
**dadurch gekennzeichnet, dass**
der Versteifungsrahmen (41) Teil der Einsatzseitenmetallisierung (20) ist.

22. Substrat nach Anspruch 20 oder 21,
**dadurch gekennzeichnet, dass**
der Versteifungsrahmen (41) im Kreuzungs- oder Überlappungsbereich mit Kontaktelementen der Einsatzseitenmetallisierung (20) Unterbrechungen (42) aufweist zur Vermeidung von Kurzschlüssen.

23. Substrat nach Anspruch 21 oder 22,
**dadurch gekennzeichnet, dass**
der Versteifungsrahmen (41) aus einem nicht-leitenden Material besteht.

24. Substrat nach Anspruch 23,
**dadurch gekennzeichnet, dass**
der Versteifungsrahmen (41) den Bereich, der für die später aufzubringende integrierte Schaltung vorgesehen ist vollständig umgibt.

25. Substrat nach einem der vorhergehenden Ansprüche,
**dadurch gekennzeichnet, dass**
das Substrat aus PEN , PET , PI oder Papier besteht.

26. Substrat nach Anspruch 25,
**dadurch gekennzeichnet, dass**
die Dicke des Substrates in etwa 50 bis 125 µm beträgt.

27. Substrat nach einem der vorhergehenden Ansprüche,
**dadurch gekennzeichnet, dass**
die Kontaktseitenmetallisierung (30) und die Einsatzseitenmetallisierung (20) durch einen Aufwachsprozess erzeugt sind.

28. Substrat nach Anspruch 27,
**dadurch gekennzeichnet, dass**
die Kontaktseitenmetallisierung (30) und die Einsatzseitenmetallisierung (20) eine Dicke von weniger als 40 µm aufweisen.

## Claims

1. Nonconducting substrate (10), forming a strip or a panel, on which a multiplicity of carrier elements (11) are formed, intended in particular for incorporation in a chip card and respectively formed by a boundary line (12), which substrate (10) has a contact side (13) and an insertion side (14), lying opposite from the contact side, the insertion side being provided with a conducting insertion-side metallization (20), which is formed in such a way that an electrical connection can take place by means of flip-chip bonding between contact points of an integrated circuit to be applied later to the insertion side and the insertion-side metallization, and, within each boundary line (12), the insertion-side metallization (20) has a plurality of contact elements (21), which are provided at least partly for bonding with flip-chip contacts of the integrated circuit, where the contact elements (21) of the insertion-side metallization (20) are made in the form of interconnects (26), which respectively have a first end (22) and a second end (23), where at least some of the interconnects (26) are provided with area-covering metallizations (27), which serve for increasing the bending rigidity of the substrate (10).

2. Substrate according to Claim 1, **characterized in that** the contact side (13) of the substrate (10) is provided with a contact-side metallization (30).

3. Substrate according to Claim 2, **characterized in that**, after the electrical punching-free, the contact-side metallization (30) comprises within each boundary line (12) a plurality of contact areas (31) electrically isolated from one another.

4. Substrate according to Claim 3, **characterized in that** the contact areas (31) of the contact-side metallization (30) are formed as ISO contact areas.

5. Substrate according to Claim 3 or 4, **characterized in that** the contact areas (31) of the contact-side metallization (30) have at least partly an electrical connection with the contact elements (21) of the insertion-side metallization (20).

6. Substrate according to Claim 5, **characterized in that** the electrical connection is established by means of plated-through holes (15) reaching through the substrate (10).

7. Substrate according to Claim 6, **characterized in that** the plated-through holes (15) are arranged in each case in a plated-through region (33) of the contact areas (31) of the contact-side metallization (30) which is not intended for bonding with an external reader (ISO zone).

8. Substrate according to one of Claims 2 to 7, **characterized in that** the contact-side metallization (30) has within each boundary line regions (32) which bring about an increased moment of resistance in the region of the integrated circuit.

9. Substrate according to Claim 8, **characterized in that** the regions (32) with an increased moment of resistance cross the line of symmetry (40), which is formed between the oppositely lying contact areas (31) of the contact-side metallization (30).

10. Substrate according to Claim 9, **characterized in that** the first end (22) of the interconnect (26) overlaps with one of the plated-through holes (15) and is in electrical connection with it.

11. Substrate according to Claim 9 or 10, **characterized in that** the second end (23) has a first contact area (24) for the electrical bonding with a flip-chip contact of the integrated circuit.

12. Substrate according to one of Claims 9 to 11, **characterized in that** at least some of the interconnects (26) have at least a further contact area (25), which is in electrical contact with the first contact area (24) of the interconnect either directly or via a portion (26a) of the interconnect (26) connected to the first contact area (24), or which is in electrical contact with the interconnect (26) via an interconnect branch, the further contact areas being respectively provided for the electrical bonding with a flip-chip contact of the integrated circuit.

13. Substrate according to Claim 12, **characterized in that** the contact areas (24) and the further contact areas (25) are designed in such a way that they serve as control marks when the integrated circuit is applied, **in that** the contact areas (24, 25) protrude slightly beyond the side edges (51) of the integrated circuit (50).

14. Substrate according to Claim 13, **characterized in that** the area-covering metallizations (27) are formed within the respective boundary lines (12) of a carrier element (11).

15. Substrate according to Claim 13 or 14, **characterized in that** the area-covering metallizations (27) are provided in a region outside the integrated circuit to be applied later.

16. Substrate according to one of the preceding claims, **characterized in that** the substrate (10) has indexing holes (16) which, to stiffen the substrate, are surrounded by metallizations (28, 35) on the insertion side (14) and/or the contact side (13).

17. Substrate according to one of the preceding claims, **characterized in that** the substrate is provided with adjusting marks (17) for the orientation of placement machines, the said marks constituting part of the insertion-side metallization (20) and/or the contact-side metallization (30).

18. Substrate according to one of the preceding claims, **characterized in that** the substrate has between neighbouring carrier elements (11) transverse webs (18) which constitute part of the insertion-side metallization (20) and/or contact-side metallization (30).

19. Substrate according to one of the preceding claims, **characterized in that**, in the region of the integrated circuit to be applied later, the insertion-side metallization (20) comprises spacers which ensure plane-parallelism between the integrated circuit and the insertion side (14) of the substrate (10).

20. Substrate according to one of the preceding claims, **characterized in that** a stiffening frame (41) is arranged on the insertion side (14) of the substrate (10) and surrounds the region intended for the integrated circuit to be applied later.

21. Substrate according to Claim 20, **characterized in that** the stiffening frame (41) is part of the insertion-side metallization (20).

22. Substrate according to Claim 20 or 21, **characterized in that** the stiffening frame (41) has, in the region where it crosses or overlaps with contact elements of the insertion-side metallization (20), interruptions (42) in order to avoid short-circuits.

23. Substrate according to Claim 21 or 22, **characterized in that** the stiffening frame (41) consists of a nonconducting material.

24. Substrate according to Claim 23, **characterized in that** the stiffening frame (41) completely surrounds the region intended for the integrated circuit to be applied later.

25. Substrate according to one of the preceding claims, **characterized in that** the substrate consists of PEN, PET, PI or paper.

26. Substrate according to Claim 25, **characterized in that** the thickness of the substrate is approximately 50 to 125 µm.

27. Substrate according to one of the preceding claims, **characterized in that** the contact-side metallization (30) and the insertion-side metallization (20) are produced by a growing-on process.

28. Substrate according to Claim 27, **characterized in that** the contact-side metallization (30) and the insertion-side metallization (20) have a thickness of less than 40 µm.

## Revendications

1. Substrat (10) non conducteur formant une bande ou un flan sur lequel est formée une pluralité d'éléments (11) de support destinés notamment à être incorporés dans une carte à puce, qui sont formés respectivement par une ligne (12) de démarcation, le substrat (10) ayant une face (13) de contact et une face (14) de service opposée à la face de contact, la face de service étant munie d'une métallisation (21) conductrice de face de service qui est telle qu'une liaison électrique entre des points de contact d'un circuit intégré à déposer ultérieurement sur la face de service et la métallisation de la face de service peut s'effectuer au moyen d'un contact flip-chip, et la métallisation (20) de la face de service ayant une multiplicité d'éléments (21) de contact à l'intérieur de chaque ligne (12) de démarcation qui sont prévus au moins pour la mise en contact avec des contacts flip-chip du circuit intégré, les éléments (21) de contact de la métallisation (20) de la face de service étant constitués sous la forme de traits (26) conducteurs qui ont respectivement une première et une deuxième extrémité (22, 23), dans lequel au moins de nombreux traits (26) conducteurs sont munis de métallisations (27) de surface qui servent à augmenter la résistance à la flexion du substrat (10).

2. Substrat suivant la revendication 1,
**caractérisé en ce que** la face (13) de contact du substrat (10) est munie d'une métallisation (30) de face de contact.

3. Substrat suivant la revendication 2,
**caractérisé en ce que** la métallisation (30) de face de contact comprend, après l'estampage électrique, une multiplicité de surfaces (31) de contact séparées électriquement les unes des autres à l'intérieur de chaque ligne (12) de démarcation.

4. Substrat suivant la revendication 3,
**caractérisé en ce que** les surfaces (31) de contact de la métallisation (30) de la face de contact sont constituées sous la forme de surfaces de contact ISO.

5. Substrat suivant la revendication 3 ou 4,
**caractérisé en ce que** les surfaces (31) de contact de la métallisation (30) de la face de contact ont au moins en partie une liaison électrique avec les éléments (21) de contact de la métallisation (20) de la face de service.

6. Substrat suivant la revendication 5,
**caractérisé en ce que** la liaison électrique est ménagée au moyen de contacts (15) traversants passant à travers le substrat (10).

7. Substrat suivant la revendication 6,
**caractérisé en ce que** les contacts (15) traversants sont disposés respectivement dans une zone (33) de contacts traversants des surfaces (30) de contact de la métallisation (30) de la face de contact, qui n'est pas destinée à venir en contact avec un appareil (champ ISO) extérieur de lecture.

8. Substrat suivant l'une des revendications 2 à 7,
**caractérisé en ce que** la métallisation (30) de la face de contact a des zones (32) à l'intérieur de chaque ligne de démarcation qui donnent une augmentation du couple résistant dans la zone du circuit intégré.

9. Substrat suivant la revendication 8,
**caractérisé en ce que** les zones (32) à augmentation du couple résistant croisent la ligne (40) de symétrie formée entre les surfaces (31) opposées de contact de la métallisation (30) de la face de contact.

10. Substrat suivant la revendication 9,
**caractérisé en ce que** la première extrémité (22) du trait (26) conducteur est à chevauchement avec l'un des contacts (15) traversants et est en liaison électrique avec celui-ci.

11. Substrat suivant la revendication 9 ou 10,
**caractérisé en ce que** la deuxième extrémité (23) a une première surface (24) de contact pour la mise en contact avec un contact flip-chip du circuit intégré.

12. Substrat suivant l'une des revendications 9 à 11,
**caractérisé en ce qu'**au moins de nombreux traits (26) conducteurs ont au moins une autre surface (25) de contact qui est en contact électrique avec la première surface (24) de contact du trait conducteur, directement ou par un tronçon (26a) du trait (26) conducteur relié à la première surface (24) de contact, ou est en contact électrique avec le trait (26) conducteur par une dérivation du trait conducteur, les autres surfaces de contact étant prévues respectivement pour la mise en contact avec un contact flip-chip du circuit intégré.

13. Substrat suivant la revendication 12,
**caractérisé en ce que** les surfaces (24) de contact et les autres surfaces (25) de contact sont telles qu'elles servent de repères de contrôle lors du dépôt du circuit intégré, par le fait que les surfaces (24, 25) de contact sont un peu en saillie au-dessus des bords (51) latéraux du circuit (50) intégré.

14. Substrat suivant la revendication 13,
**caractérisé en ce que** les métallisations (27) de surfaces sont constituées à l'intérieur des lignes (12) de démarcation respectives d'un élément (11) de support.

15. Substrat suivant la revendication 13 ou 14,
**caractérisé en ce que** les métallisations (27) de surfaces sont prévues dans une zone à l'extérieur du circuit intégré à déposer ultérieurement.

16. Substrat suivant l'une des revendications précédentes,
**caractérisé en ce que** le substrat (10) a des trous (16) d'indexation qui sont entourés de métallisations (28, 35) sur la face (14) de service et/ou sur la face (13) de contact pour rigidifier le substrat.

17. Substrat suivant l'une des revendications précédentes,
**caractérisé en ce que** le substrat est muni de repères (17) d'ajustement pour l'orientation de machines d'implantation, les repères faisant partie de la métallisation (20, 30) de la face de service et/ou de la face de contact.

18. Substrat suivant l'une des revendications précédentes,
**caractérisé en ce que** le substrat a des traverses (18) entre des éléments (11) de support voisins, ces traverses faisant partie de la métallisation (20, 30) de la face de service et/ou de la face de contact.

19. Substrat suivant l'une des revendications précédentes,
**caractérisé en ce que** la métallisation (20) de la face de service comprend, dans la zone du circuit intégré à déposer ultérieurement, des espaceurs qui servent au parallélisme des plans entre le circuit intégré et la face (14) de service du substrat (10).

20. Substrat suivant l'une des revendications précédentes,
**caractérisé en ce qu'**il est disposé sur la face (14) de service du substrat (10) un cadre (41) de renfort qui entoure la zone prévue pour le circuit intégré à déposer ultérieurement.

21. Substrat suivant la revendication 20,
**caractérisé en ce que** le cadre (41) de renfort fait partie de la métallisation (20) de la face de service.

22. Substrat suivant la revendication 20 ou 21,
**caractérisé en ce que** le cadre (41) de renfort a, dans la zone de croisement ou de chevauchement avec des éléments de contact de la métallisation (20) de la face de service, des interruptions pour empêcher les courts-circuits.

23. Substrat suivant la revendication 21 ou 22,
**caractérisé en ce que** le cadre (41) de renfort est en un matériau non conducteur.

24. Substrat suivant la revendication 23,
**caractérisé en ce que** le cadre (41) de renfort entoure complètement la zone qui est prévue pour le circuit intégré à déposer ultérieurement.

25. Substrat suivant l'une des revendications précédentes,
**caractérisé en ce que** le substrat est en PEN, en PET, en PI ou en papier.

26. Substrat suivant la revendication 25,
**caractérisé en ce que** l'épaisseur du substrat est d'environ 50 à 125 µm.

27. Substrat suivant l'une des revendications précédentes,
**caractérisé en ce que** la métallisation (30) de la face de contact et la métallisation (20) de la face de service sont produites par un processus de croissance.

28. Substrat suivant la revendication 27,
**caractérisé en ce que** la métallisation (30) de la face de contact et la métallisation (20) de la face de service ont une épaisseur inférieure à 40 µm.
